# EUROPÄISCHE PATENTSCHRIFT

(11) **EP 4 519 709 B1**
(45) Veröffentlichungstag und Bekanntmachung des Hinweises auf die Patenterteilung: **08.04.2026**
(21) Anmeldenummer: 23722826.7
(22) Anmeldetag: 05.05.2023
(51) Int. Cl.: G07D 7/04, G01R 33/44, G01N 24/08, G01N 24/10, G01R 33/345, G01R 33/38, G01R 33/383, G01R 33/60

(54) **SENSORELEMENT, PRÜFVORRICHTUNG UND VERFAHREN FÜR DIE PRÜFUNG EINES DATENTRÄGERS MIT SPINRESONANZ-MERKMAL**
SENSOR ELEMENT, TEST DEVICE, AND METHOD FOR TESTING A DATA CARRIER HAVING A SPIN RESONANCE FEATURE
ÉLÉMENT CAPTEUR, DISPOSITIF DE TEST ET PROCÉDÉ DE TEST DE SUPPORT DE DONNÉES AYANT UNE CARACTÉRISTIQUE DE RÉSONANCE DE SPIN

(30) Priorität: 06.05.2022 DE 102022001593
(43) Veröffentlichungstag der Anmeldung: 12.03.2025
(73) Patentinhaber: Giesecke+Devrient Currency Technology GmbH, 81677 München (DE)
(72) Erfinder: HUBER, Stephan, 80634 München (DE); HAPP, Thomas, 81825 München (DE)
(74) Vertreter: Giesecke+Devrient IP
(86) Internationale Anmeldenummer: PCT/EP2023/025210
(87) Internationale Veröffentlichungsnummer: WO 2023/213439

(56) Entgegenhaltungen:
- EP-A2- 1 646 057
- DE-A1- 3 408 086
- US-A- 5 149 946
- US-A- 5 302 898
- US-A1- 2004 251 904

## Beschreibung

Die Erfindung betrifft ein Sensorelement für die Echtheitsprüfung eines flächigen Datenträgers, insbesondere einer Banknote, mit einem Spinresonanz-Merkmal. Die Erfindung betrifft auch eine Prüfvorrichtung mit einem solchen Sensorelement und ein Verfahren zur Echtheitsprüfung mit einem solchen Sensorelement oder einer solchen Prüfvorrichtung.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Es ist bekannt, bei der maschinellen Echtheitsprüfung Sicherheitselemente mit Spinresonanz-Merkmalen zur Absicherung von Dokumenten und anderen Datenträgern einzusetzen. Die Sicherheitselemente sind dazu mit Substanzen versehen, die eine Spinresonanz-Signatur aufweisen. Zu den für die Echtheitsprüfung einsetzbaren Spinresonanz-Signaturen gehören insbesondere Kernspin-Resonanz-Effekte (Nuclear Magnetic Resonance, NMR), Elektronspin-Resonanz-Effekte (ESR) und ferromagnetische Resonanz-Effekte (FMR).

Bei der Prüfung von Banknoten werden zur Detektion der Spinresonanz-Signaturen meist drei verschiedene Magnetfelder im Messbereich beispielsweise einer Banknotenbearbeitungsmaschine erzeugt. Dabei handelt es sich konkret um ein quasistatisches Polarisationsfeld B₀, das parallel zur Axialrichtung (z-Richtung) des Luftspalts eines magnetischen Kreises verläuft. Ein zweites Magnetfeld ist durch ein Modulationsfeld B_{mod} gebildet, welches ebenfalls parallel zur z-Achse verläuft und typischerweise eine Frequenz f_{mod} im kHz-Bereich hat. Zur Anregung von Übergängen zwischen den aufgespaltenen Spin-Energieniveaus der Spinresonanz-Signatur-Substanzen ist ein Anregefeld B₁ vorgesehen, das senkrecht zur B₀-Richtung polarisiert ist. Das Anregefeld schwingt dabei mit der Resonanzfrequenz des Materials, die auch als Larmorfrequenz bezeichnet wird, und die proportional zum Polarisationsfeld B₀ ist.

Zur Erzeugung des Polarisationsfeldes B₀ kommt häufig ein magnetischer Kreis zum Einsatz, der den magnetischen Fluss von Permanentmagneten und/oder Spulen zu einem Luftspalt leitet, in dem die Prüfung der flächigen Datenträger stattfindet.

Für die Erzeugung des Anregefelds B₁ wird ein Hochfrequenz-Resonator, beispielsweise ein Streifenleitungs-Resonator, verwendet. Dabei handelt es sich um eine leitende Struktur mit einer charakteristischen Länge I, die auf einem Träger angeordnet ist. Passt bei der Echtheitsprüfung die Wellenlänge λ des eingekoppelten Hochfrequenzsignals zu der Abmessung I der leitenden Struktur, so kann sich im Resonator eine stehende Welle ausbilden und der Streifenleitungs-Resonator ist zu der zur Wellenlänge λ gehörenden Anregefrequenz in Resonanz. Da die Ausdehnung eines Streifenleitungs-Resonators in der Ebene des Trägers deutlich größer ist als senkrecht dazu, spricht man auch von der Ebene des Streifenleitungs-Resonators, die der Ebene des Trägers entspricht.

Bei der Prüfung eines Datenträgers, etwa im Rahmen einer Echtheitsprüfung, wird oft ein Spinresonanz-Spektrum des Spinresonanz-Merkmals bestimmt und anhand charakteristischer Kennzeichen mit einem erwarteten Spektrum verglichen. Typischerweise werden Spinresonanz-Spektren in einem zeitintensiven B₀-Ramp-Verfahren (auch B₀-Sweep-Verfahren genannt) aufgezeichnet. Dabei wird das statische Polarisationsfeld B₀ bei fester Frequenz des Anregefelds B₁ um die Resonanzfeldstärke herum langsam variiert und damit die Feldstärke des Polarisationsfelds B₀ durchfahren. Da die Larmorfrequenz eines zu prüfenden Spinresonanz-Merkmals proportional zur Polarisationsfeldstärke B₀ ist, wird dadurch effektiv die Anregefrequenz gegen die Larmorfrequenz verschoben, was die Aufnahme eines Frequenzspektrums des Spinresonanz-Merkmals erlaubt. Da die zeitliche Änderung der Feldstärke des Polarisationsfelds B₀ beim B₀-Ramp-Verfahren sehr viel langsamer ist als die zeitliche Änderung des Modulationsfelds B_{mod} und des Anregefelds B₁, wird B₀ im Rahmen dieser Anmeldung vorzugsweise auch bei Vorliegen eines Rampfeldes als statisches Magnetfeld bzw. statischer magnetischer Fluss bezeichnet.

Insbesondere in schnell-laufenden Banknoten-Bearbeitungsmaschinen erfordert der Sensorbetrieb allerdings kurze Messzeiten, die nicht ausreichen, um mit einer Rampe (oft auch: sweep) das vollständige Spektrum eines Spinresonanz-Merkmals messen zu können. Frequenzspektren können dann nur mit wenigen Messpunkten, also mit geringer Auflösung oder über ein schmales Frequenzband, aufgenommen werden. Für viele Anwendungen ist aber eine spektral hoch aufgelöste, breitbandige Messung wünschenswert, beispielsweise um Merkmalsstoffe mit verschiedenen Larmorfrequenzen unterscheiden zu können. Auch können bei hoher Spektralauflösung Spinresonanz-Merkmale mit spektralem Code, beispielsweise für verschiedene Währungen oder verschiedene Denominationen, verwendet werden.

US 2004/251904 A1 beschreibt zum Beispiel ein magnetisches Resonanzverfahren zur Bestimmung mindestens einer Eigenschaft von mehreren Proben. Mehrere Proben werden gleichzeitig in eine Abfragezone eingebracht, an die ein magnetisches Gradientenfeld angelegt wird, wobei unterschiedliche Positionen innerhalb der Abfragezone auf unterschiedliche spezifische Frequenzen reagieren.

Ausgehend davon liegt der Erfindung die Aufgabe zugrunde, eine verbesserte Vorrichtung für die Prüfung von Datenträgern mit Spinresonanz-Merkmalen anzugeben, und insbesondere ein Sensorelement bereitzustellen, das in kurzer Zeit eine spektral hoch aufgelöste und/oder breitbandige Messung der Spinresonanz eines zu prüfenden Datenträgers erlaubt.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung, insbesondere Echtheitsprüfung, eines flächigen Datenträgers mit einem Spinresonanz-Merkmal bereit. Bei dem flächigen Datenträger kann es sich beispielsweise um eine Banknote handeln. Das Sensorelement enthält einen Magnetkern mit einem Luftspalt, in den der flächige Datenträger zur Prüfung einbringbar ist, eine Polarisationseinrichtung zu Erzeugung eines statischen magnetischen Flusses in dem Luftspalt, sowie eine Resonatoreinrichtung zur Anregung des Spinresonanz-Merkmals des zu prüfenden Datenträgers in dem Luftspalt.

Die Resonatoreinrichtung enthält zumindest zwei, an verschiedenen Positionen im Luftspalt angeordnete Streifenleitungs-Resonatoren. Weiter erzeugt die Polarisationseinrichtung in dem Luftspalt des Magnetkerns einen inhomogenen magnetischen Fluss, so dass der statische magnetische Fluss an der Position eines ersten Streifenleitungs-Resonators eine erste Feldstärke aufweist und an der Position eines zweiten Streifenleitungs-Resonators eine zweite, unterschiedliche Feldstärke aufweist. Bei dem Spinresonanz-Merkmal handelt es sich bevorzugt um ein ESR-Merkmal.

Wie nachfolgend genauer erläutert, ermöglicht die Anordnung von mehreren Streifenleitungs-Resonatoren an verschiedenen Positionen eines inhomogenen Polarisationsfelds die gleichzeitige Messung der Spinresonanz bei verschiedenen Polarisationsfeldstärken und erlaubt damit eine höhere Spektralauflösung und/ oder kürzere Messzeiten. Auch die Anforderungen an eine Feldrampe zur Vermessung einer Spektrallinie werden deutlich verringert.

Die eingesetzten Streifenleitungs-Resonatoren zeichnen sich grundsätzlich insbesondere dadurch aus, dass ihr sensitiver Bereich sehr gut zugänglich ist, und sie für flächige Proben, wie sie die zu prüfenden Banknoten darstellen, einen sehr hohen Füllfaktor aufweisen. Die Streifenleitungs-Resonatoren werden nachfolgend teilweise auch nur kurz als Resonatoren bezeichnet.

In einer vorteilhaften Ausgestaltung sind die Streifenleitungs-Resonatoren der Resonatoreinrichtung in Form eines eindimensionalen Arrays angeordnet. Vorzugsweise ist das eindimensionale Array dabei parallel zu einem Gradienten des magnetischen Flusses im Luftspalt angeordnet.

In einer anderen, ebenfalls bevorzugten Ausgestaltung bilden die Streifenleitungs-Resonatoren der Resonatoreinrichtung eine Mehrspur-Anordnung mit mehreren parallelen Spuren, bei der jede Spur durch ein eindimensionales Array von Streifenleitungs-Resonatoren gebildet ist. Vorzugsweise ist das eindimensionale Array jeder Spur parallel zu einem Gradienten des magnetischen Flusses im Luftspalt angeordnet.

Die Resonatoreinrichtung kann insbesondere zwei, drei, vier, fünf oder sechs Streifenleitungs-Resonatoren enthalten, wobei auch eine größere Anzahl an Streifenleitungs-Resonatoren, beispielsweise eine Mehrspur-Anordnung mit zwei oder drei Spuren mit je fünf Streifenleitungs-Resonatoren, vorteilhaft sein kann. Eine Vergrößerung der Anzahl an Streifenleitungs-Resonatoren hat den Vorteil einer besseren spektralen Auflösung oder einer kürzeren erforderlichen Messzeit.

Mit Vorteil ist vorgesehen, dass die an verschiedenen Positionen im Luftspalt angeordneten Streifenleitungs-Resonatoren jeweils von einer anderen Signalquelle gespeist sind.

In einer vorteilhaften Ausgestaltung ist der Luftspalt durch zwei Polflächen des Magnetkerns begrenzt, wobei eine oder beide Polflächen abgeschrägt und/oder gestuft ausgebildet sind. Insbesondere kann vorgesehen sein, dass die beiden Polflächen einen Winkel zueinander bilden, der vorzugsweise zwischen 1° und 10° liegt. Da die Feldstärke des Polarisationsfelds im Luftspalt umgekehrt proportional zum lokalen Abstand der beiden Polflächen ist, kann durch eine abgeschrägte bzw. gestufte Ausbildung der Polflächen ein gewünschtes inhomogenes Polarisationsfeld im Luftspalt erzeugt werden. An den Polflächen besteht der Magnetkern dabei bevorzugt aus einem ferromagnetischen Material mit einer magnetischen Permeabilität µr >>1, also insbesondere µr größer als 1×10².

In einer anderen, ebenfalls vorteilhaften Ausgestaltung ist der magnetische Leiter des Magnetkerns mit einem Flussleitstück versehen, dessen magnetischer Widerstand sich von dem magnetischen Widerstand des magnetischen Leiters unterscheidet. Durch die Formgebung des Flussleitstücks kann die Stärke des Polarisationsfelds im Luftspalt eingestellt und ein gewünschtes inhomogenes Polarisationsfeld erzeugt werden. Das Flussleitstück kann insbesondere keilförmig oder stufenförmig ausgebildet sein, um eine linear bzw. stufenförmig zunehmende oder linear bzw. stufenförmig abnehmende Feldstärke im Luftspalt zu erzeugen. Wird ein Flussleitstück zur Erzeugung des inhomogenen magnetischen Flusses eingesetzt, so sind die den Luftspalt begrenzenden Polflächen vorteilhaft planparallel zueinander. Dies erleichtert den ungestörten Transport der Datenträger durch den Luftspalt. In diesem Fall können die Polflächen auch von einem paramagnetischen Material mit µr ≈ 1 gebildet werden, also insbesondere µr höchstens 1+10⁻².

Die Streifenleitungs-Resonatoren der Resonatoreinrichtung haben vorteilhaft die gleiche Resonanzfrequenz, beispielsweise weichen die Resonanzfrequenzen der Streifenleitungs-Resonatoren um weniger als 1%, bevorzugt um weniger als 0.1% voneinander ab. Vorzugsweise sind die Streifenleitungs-Resonatoren der Resonatoreinrichtung sogar auf Betrieb in der gleichen räumlichen Mode ausgelegt und eingerichtet. Weiter ist alternativ oder zusätzlich mit Vorteil vorgesehen, dass die Streifenleitungs-Resonatoren der Resonatoreinrichtung eine gleiche geometrische Form, beispielsweise eine quadratische, eine rechteckige oder eine Ring-Form aufweisen.

Die genannte erste Feldstärke unterscheidet sich von der genannten zweiten Feldstärke vorteilhaft um mindestens 2%, vorzugsweise um mindestens 5%, insbesondere um mindestens 10%.

Die Polarisationseinrichtung kann insbesondere einen über die Ausdehnung des Luftspalts linear zunehmenden oder abnehmenden Fluss, oder einen stufenweise zunehmenden oder abnehmenden Fluss erzeugen.

In einer vorteilhaften Ausgestaltung weist das Sensorelement weiter eine Modulationseinrichtung zur Erzeugung eines zeitlich variierenden magnetischen Modulationsfelds in dem Luftspalt auf, wobei bevorzugt die Modulationsfrequenz bei allen Streifenleitungs-Resonatoren der Resonatoreinrichtung gleich hoch ist. Beispielsweise weicht die Modulationsfrequenz am Ort von je zwei Streifenleitungs-Resonatoren um höchstens 2% voneinander ab. Die Modulationseinrichtung ist vorteilhaft durch eine im Luftspalt angeordnete Einzel-Modulationsspule, insbesondere eine Einzel-Planarspule, gebildet.

Mit Vorteil sind die Streifenleitungs-Resonatoren flächig mit einer Haupterstreckungsebene ausgebildet, welche senkrecht auf der Richtung des von der Polarisationseinrichtung erzeugten statischen magnetischen Flusses steht. Im Rahmen dieser Beschreibung wird die Richtung des statischen magnetischen Flusses auch als z-Richtung bezeichnet. Die Haupterstreckungsebene der Streifenleitungs-Resonatoren erstreckt sich dann in der zur z-Richtung senkrechten x-y-Ebene.

Der Luftspalt weist vorteilhaft eine Höhe, also eine Abmessung in z-Richtung, von weniger als 10 mm, vorzugsweise von weniger als 5 mm auf. Dadurch lässt sich ein besonders starkes Polarisationsfeld, also ein starker statischer magnetischer Fluss im Luftspalt erzeugen.

Bei einer vorteilhaften Weiterbildung der Erfindung ist zur Erhöhung des Signal-zu-Rausch-Verhältnisses zumindest ein Teil der genannten, an verschiedenen Positionen bei verschiedenen Feldstärken des magnetischen Flusses angeordneten Streifenleitungs-Resonatoren jeweils durch ein NxM-Array von Streifenleitungs-Resonatoren ersetzt, wobei N und M natürliche Zahlen sind und zumindest einer der Werte von N und M größer als 1 ist, wobei die Streifenleitungs-Resonatoren des NxM-Arrays jeweils alle von derselben Signalquelle gespeist sind und elektrisch parallel und/ oder in Reihe geschaltet sind.

In einer besonders vorteilhaften Ausgestaltung weist das Sensorelement weiter eine Rampspule zur Erzeugung einer Rampenfunktion des statischen magnetischen Flusses auf.

Die Resonatoreinrichtung ist mit Vorteil auf die Anregung von Spinresonanz-Signalen mit einer Frequenz oberhalb von 1 GHz, insbesondere zwischen 1 GHz und 10 GHz, ausgelegt. Gegenüber niedrigeren Frequenzen ermöglicht dies eine höhere spektrale Auflösung und ein stärkeres Messsignal.

Die Resonatoreinrichtung ist insbesondere auch zur Erfassung von Spinresonanz-Signalen des Spinresonanz-Merkmals ausgebildet. Die Resonatoreinrichtung kann insbesondere ein Antwortsignal des Spinresonanz-Merkmals aufnehmen und an einen Detektor ausgeben. Die Spinresonanzen können beispielsweise mit einem Dauerstrich (CW)-Verfahren, einem gepulsten Verfahren oder einem Rapid-Scan-Verfahren bestimmt werden.

Die Streifenleitungs-Resonatoren können bei der Prüfung des Datenträgers sowohl in Reflexion als auch in Transmission betrieben werden. Letzteres hat den Vorteil, dass im Signalzweig kein Element wie etwa ein Zirkulator benötigt wird, das die zum Resonator vor- und rücklaufenden Signale auftrennt.

Mit Vorteil umfasst die Resonatoreinrichtung einen flächigen Träger, auf dem die Streifenleitungs-Resonatoren aufgebracht sind. Der Träger ist zweckmäßig durch eine Leiterplatte gebildet, was eine reproduzierbare und kostengünstige Herstellung erlaubt. Es ist allerdings auch vorteilhaft, insbesondere zur Verringerung dielektrischer Verluste im Trägermaterial, Träger auf Basis von Keramik, Teflon oder Kohlenwasserstoffen einzusetzen.

Die Erfindung enthält auch eine Prüfvorrichtung für die Prüfung eines flächigen Datenträgers, insbesondere einer Banknote, mit einem Spinresonanz-Merkmal mit einem Sensorelement der oben beschriebenen Art und mit einer oder mehreren Signalquelle(n), aus denen die an verschiedenen Positionen im Luftspalt angeordneten Streifenleitungs-Resonatoren der Resonatoreinrichtung gespeist sind.

In einer vorteilhaften Ausgestaltung sind dabei mehrere Signalquellen vorgesehen, aus denen jeweils einer der an verschiedenen Positionen im Luftspalt angeordneten Streifenleitungs-Resonatoren der Resonatoreinrichtung gespeist ist. Das Betreiben der Resonatoren mit Hilfe von unabhängigen Signalquellen erfordert allerdings auch, dass die Resonatoren an unabhängige Signalzweige angebunden werden. Insbesondere bei einer hohen Anzahl an Resonatoren wird dafür viel Bauraum zur Schaltungsimplementierung benötigt. Bevorzugt werden die mehreren Signalquellen dabei bei derselben Anregefrequenz betrieben, beispielsweise mit einer Frequenzabweichung von weniger als 1%, bevorzugt von weniger als 0,1 %.

Es ist daher mit Vorteil ebenfalls möglich, dass die an verschiedenen Positionen im Luftspalt angeordneten Streifenleitungs-Resonatoren über einen Multiplexer von nur einer einzigen Signalquelle gespeist sind. In diesem Fall liegt nur ein einziger Signalzweig vor und alle Resonatoren sind mit diesem Signalzweig verbunden. Der benötigte Bauraum ist bei dieser Ausführung somit deutlich geringer, und es ist ohne Weiteres sichergestellt, dass alle Resonatoren bei derselben Anregefrequenz betrieben werden. Da bei diesem Verfahren gleichzeitig nur mit einem einzigen Resonator gemessen werden kann, ist die Schaltzeit τ des Multiplexers vorzugsweise so auf den Abstand d hintereinander liegender Resonatoren abgestimmt, dass bei einem mit der Geschwindigkeit v bewegten Datenträger die spektralen Einzelkomponenten immer am gleichen Ort auf dem Datenträger gemessen werden, dass also τ = d/v gilt. In Transportrichtung betrachtet entstehen bei diesem Verfahren Lücken zwischen den Orten auf dem Datenträger, an denen die Spinresonanz gemessen wird, es gibt also auch Orte, an denen keine Messung vorgenommen wird.

Alternativ kann die Schaltzeit des Multiplexers auf Werte τ ≪ d/v verringert werden. Dies führt auf Grund der kleineren Messzeit je Resonator zwar zu einem geringeren Signal-Rausch-Verhältnis, dafür kann die spektrale Signatur der Banknote über größere Bereiche und im Wesentlichen ohne Lücken erfasst werden.

Vorteilhaft enthält die Prüfvorrichtung weiter eine Transporteinrichtung, die die zu prüfenden flächigen Datenträger entlang eines Transportpfades durch den Luftspalt des Magnetkerns führt, wobei der Transportpfad vorteilhaft parallel zu einem Gradienten des magnetischen Flusses im Luftspalt ist. Bevorzugt ist dabei vorgesehen, dass
- entweder die Streifenleitungs-Resonatoren der Resonatoreinrichtung in der oben beschriebenen Art in Form eines eindimensionalen Arrays parallel zu dem Transportpfad angeordnet sind,
- oder die Streifenleitungs-Resonatoren eine Mehrspur-Anordnung in der oben beschriebenen Art bilden, bei der jede der Spuren parallel zu dem Transportpfad ist.

Die Transporteinrichtung ist insbesondere auf einen schnell-laufenden Transport, beispielsweise zwischen 1 m/ s und 12 m/s, der zu prüfenden flächigen Datenträger entlang des Transportpfades ausgelegt und eingerichtet.

Die Erfindung enthält auch ein Verfahren zur Prüfung eines flächigen Datenträgers, insbesondere einer Banknote, mit einem Spinresonanz-Merkmal mittels eines Sensorelements der beschriebenen Art oder einer Prüfvorrichtung der beschriebenen Art, wobei bei dem Verfahren
- ein zu prüfender flächiger Datenträger entlang eines Transportpfades durch den Luftspalt des Magnetkerns des genannten Sensorelements geführt wird, wobei eine Mehrzahl von Streifenleitungs-Resonatoren der Resonatoreinrichtung parallel zu dem Transportpfad hintereinander liegen,
- mit der Polarisationseinrichtung in dem Luftspalt des Magnetkerns ein inhomogener magnetischer Fluss und vorzugsweise mit einer Modulationseinrichtung ein zeitlich variierendes magnetisches Modulationsfeld in dem Luftspalt erzeugt wird, und
- mit der Resonatoreinrichtung das Spinresonanz-Merkmal des zu prüfenden Datenträgers angeregt wird.

Bei einer vorteilhaften Verfahrensführung ist vorgesehen, dass
- der zu prüfende Datenträger an den hintereinander liegenden Streifenleitungs-Resonatoren vorbeigeführt wird, und von den Streifenleitungs-Resonatoren jeweils eine zeitliche Messreihe des nach Anregung erzeugten Antwortsignals des Spinresonanz-Merkmals aufgenommen wird,
- aus den zeitlichen Messreihen der Streifenleitungs-Resonatoren jeweils zum selben Messfleck gehörende Messdaten identifiziert werden,
- aus den identifizierten Messdaten eine spektrale Information über das Spinresonanz-Merkmal abgeleitet wird, und
- der Datenträger anhand der abgeleiteten spektralen Information bewertet wird, insbesondere auf Echtheit und/oder Zugehörigkeit zu einer Datenträgerklasse.

Die Messdaten werden dabei vorteilhaft räumlich aufgelöst oder räumlich gemittelt.

Gemäß einer vorteilhaften Weiterbildung des Verfahrens ist vorgesehen, dass
- dem inhomogenen statischen magnetischen Fluss ein räumlich homogenes Rampfeld überlagert wird, so dass der gesamte statische magnetische Fluss im Luftspalt zeitlich zwischen einem Minimalwert und einem Maximalwert variiert,
- die spektrale Information aus den identifizierten Messdaten unter Berücksichtigung der Feldstärke des statischen magnetischen Flusses zum jeweiligen Messzeitpunkt abgeleitet wird, und
- anhand der abgeleiteten spektralen Information die Echtheit des geprüften Datenträgers und/oder die Zugehörigkeit des geprüften Datenträgers zu einer von mehreren Datenträgerklassen mit unterschiedlichen Spektralsignaturen bestimmt wird.

Wie beschrieben, sind die Streifenleitungs-Resonatoren in einer bevorzugten Ausführung entlang einer Transportrichtung des Datenträgers hintereinander angeordnet und der Gradient des Polarisationsfelds ist parallel zur Transportrichtung. Dies hat den Vorteil, dass alle Resonatoren dieselbe Spur auf dem Datenträger messen, also mit einem gewissen Zeitversatz dieselben Messpunkte. Dies erleichtert die Auswertung und die Prüfung des Datenträgers.

Auch ein Mehrspur-Aufbau zur Erzeugung einer Ortsauflösung quer zur Transportrichtung ist vorteilhaft. Dazu werden mehrere Spuren mit jeweils einem eindimensionalen Array von Resonatoren für die Spektralauflösung aufgebaut.

In einer weiteren vorteilhaften Ausgestaltung ist vorgesehen, dass der Gradient des Polarisationsfelds quer oder schräg zur Transportrichtung des Datenträgers zeigt. Die Streifenleitungs-Resonatoren der Resonatoreinrichtung können aus der Transportrichtung betrachtet auch nebeneinander angeordnet sein. Bevorzugt sind allerdings bei allen Gestaltungen die Resonatoren zumindest teilweise auf einer Linie angeordnet, die parallel zum Gradienten des Polarisationsfelds liegt, da so die größten Unterschiede in der Feldstärke B₀ erzielt werden. Grundsätzlich sind jedoch auch andere Anordnungen möglich, es muss lediglich sichergestellt sein, dass zumindest zwei Resonatoren der Resonatoreinrichtung an Positionen mit unterschiedlicher Polarisationsfeldstärke angeordnet sind.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Fig. 1: schematisch eine Prüfvorrichtung eines Banknotenbearbeitungssystems für die Messung von Spin-Resonanzen eines Banknotenprüflings,
- Fig. 2: im oberen Teil schematisch in Aufsicht die Resonatoreinrichtung der Prüfvorrichtung der Fig. 1 und den zugeführten Banknotenprüfling und im unteren Teil schematisch den Verlauf des inhomogenen Polarisationsfelds,
- Fig. 3: das vereinfachte Spektrum einer Spinresonanz-Linie als Funktion des Polarisationsfelds B₀ bei fester Anregefrequenz,
- Fig. 4: Diagramme zur Illustration der Aufzeichnung des Spinresonanz-Spektrums der Spinresonanz-Linie der Fig. 3, in (a) mit einem herkömmlichen Sensorelement und in (b) mit einem erfindungsgemäßen Sensorelement,
- Fig. 5: in (a) eine herkömmliche Polarisationseinrichtung und in (b) bis (d) Polarisationseinrichtungen zur Erzeugung eines inhomogenen magnetischen Flusses im Luftspalt eines Magnetkreises,
- Fig. 6: das Spektrum des Spinresonanz-Merkmals einer Papierprobe, und
- Fig. 7: Signalkurven bei der Messung des Spinresonanz-Merkmals der Papierprobe der Fig. 6 mit einem erfindungsgemäßen Sensorelement.

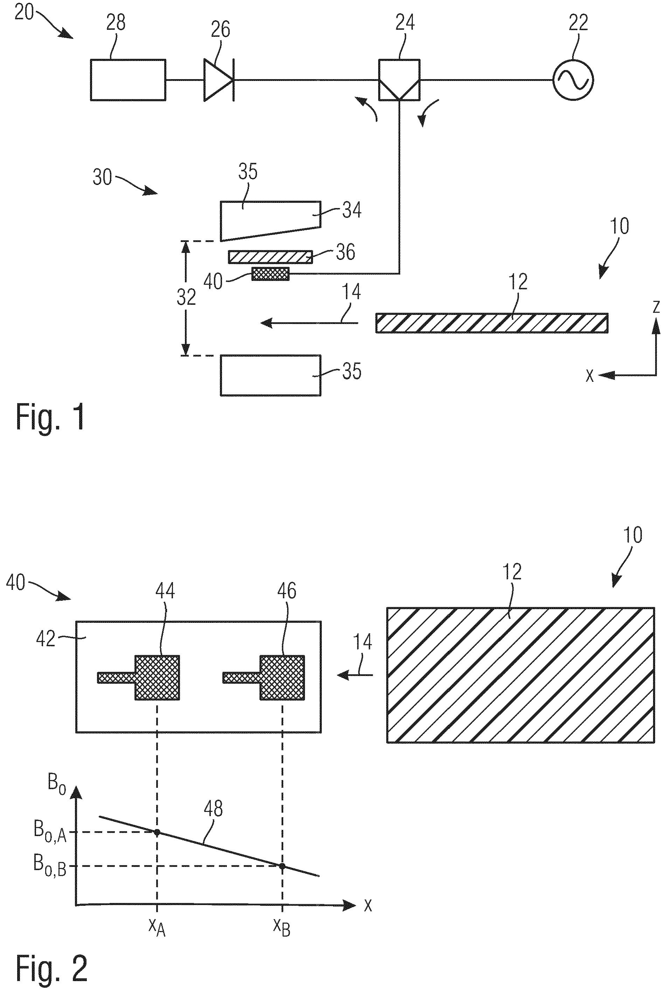

Die Erfindung wird nun am Beispiel der Echtheitsprüfung von Banknoten erläutert. Figur 1 zeigt dazu schematisch eine Prüfvorrichtung 20 eines Banknotenbearbeitungssystems für die Messung von Spin-Resonanzen eines Banknotenprüflings 10.

Der Banknotenprüfling 10 weist ein Spinresonanz-Merkmal 12 auf, dessen charakteristische Eigenschaften zum Nachweis der Echtheit der Banknote dienen. Das Spinresonanz-Merkmal kann nur in einem Teilbereich der Banknote vorliegen oder kann sich, wie im gezeigten Ausführungsbeispiel, auch über die gesamte Fläche des Banknotenprüflings erstrecken.

Die Prüfvorrichtung 20 enthält ein Sensorelement 30 mit einem Magnetkern 35 mit einem Luftspalt 32, durch den der Banknotenprüfling 10 bei der Echtheitsprüfung entlang eines Transportpfads 14 geführt wird. Zur Detektion von Spinresonanz-Signaturen des Spinresonanz-Merkmals 12 erzeugt das Sensorelement 30 in einem Messbereich des Luftspalts 32 drei verschiedene Magnetfelder.

Zum einen wird durch eine Polarisationseinrichtung 34 ein statischer magnetischer Fluss parallel zur z-Achse im Messbereich erzeugt. Wie nachfolgend genauer beschrieben, erzeugt die Polarisationseinrichtung 34 einen inhomogenen magnetischen Fluss im Luftspalt 32, so dass die Feldstärke des Polarisationsfelds B₀ an verschiedenen Stellen entlang des Transportpfads 14 unterschiedlich groß ist.

Zum zweiten erzeugt eine Modulationseinrichtung 36 ein zeitlich variierendes magnetisches Modulationsfeld in dem Luftspalt, das ebenfalls parallel zur z-Achse verläuft und eine Modulationsfrequenz f_{Mod} im Bereich zwischen 1 kHz bis 1 MHz aufweist. Schließlich erzeugt eine im Luftspalt 32 angeordnete Resonatoreinrichtung 40 ein Anregefeld B₁, das Energieübergänge zwischen den Spin-Energieniveaus im Spinresonanz-Merkmal 12 induziert. Die Resonatoreinrichtung 40 enthält dabei zumindest zwei an verschiedenen Positionen im Luftspalt angeordnete Streifenleitungs-Resonatoren, die aufgrund der Inhomogenität des magnetischen Flusses unterschiedliche Feldstärken erfahren.

Die Frequenz des Anregefelds liegt typischerweise oberhalb von 1 GHz und ist auf die Larmor-Frequenz des nachzuweisenden Spinresonanz-Merkmals 12 abgestimmt, um dessen Spinresonanz-Signatur messen und für die Echtheitsprüfung verwenden zu können. Die Prüfvorrichtung 20 enthält hierzu eine Signalquelle 22, deren Anregefrequenz f_{MW} der erwarteten Larmor-Frequenz des Spinresonanz-Merkmals 12 entspricht. Das Anregesignal der Signalquelle 22 wird über einen Duplexer 24 einer Resonatoreinrichtung 40 zugeführt und erzeugt dort ein magnetisches Wechselfeld der Frequenz f_{MW}.

Neben den genannten Elementen enthält die Prüfvorrichtung 20 eine Detektor-Diode 26 zur Messung der von der Resonatoreinrichtung 40 reflektierten Hochfrequenz-Leistung und eine Auswerteeinheit 28 zur Auswertung und gegebenenfalls Anzeige des Messergebnisses. Ist das Spinresonanz-Merkmal 12 bei einer eingekoppelten Frequenz f_{MW} in Resonanz, so ändert sich die Resonatorgüte und damit die von den Streifenleitungs-Resonatoren reflektierte Leistung. Aufgrund der Modulation des statischen Polarisationsfelds durch die Modulationseinrichtung 36 oszilliert der genaue Wert der Larmor-Frequenz der Probe, so dass das erhaltene Messsignal mit der Modulationsfrequenz amplitudenmoduliert ist.

Zur näheren Erläuterung der Besonderheiten der vorliegenden Erfindung zeigt Fig. 2 im oberen Teil der Figur in Aufsicht schematisch eine Resonatoreinrichtung 40 nach einem Ausführungsbeispiel der Erfindung mit einem Träger 42 und den auf dem Träger angeordneten ersten und zweiten Streifenleitungs-Resonatoren 44, 46. Die beiden Streifenleitungs-Resonatoren 44, 46 sind in der Transportrichtung 14 hintereinander angeordnet und werden daher von dem Spinresonanz-Merkmal 12 der Banknote 10 mit einem Zeitversatz nacheinander überstrichen. Die beiden Streifenleitungs-Resonatoren 44, 46 sind unabhängig voneinander beschaltet, haben aber eine identische geometrische Form und identische Resonanzfrequenzen f.

Der untere Teil der Fig. 2 zeigt schematisch den Verlauf 48 des inhomogenen Polarisationsfelds B₀ entlang der x-Richtung und insbesondere am Ort der Streifenleitungs-Resonatoren 44, 46. Im Ausführungsbeispiel hat die Feldstärke des Polarisationsfelds B₀ entlang der Transportrichtung 14 einen linearen Verlauf. Ein erster Streifenleitungs-Resonator 44 befindet sich an einer Position x_{A} mit der Polarisationsfeldstärke B_{0,A}, während sich der von der Banknote 10 zuerst überstrichene zweite Streifenleitungs-Resonator 46 an einer Position x_{B} mit der kleineren Polarisationsfeldstärke B_{0,B} befindet.

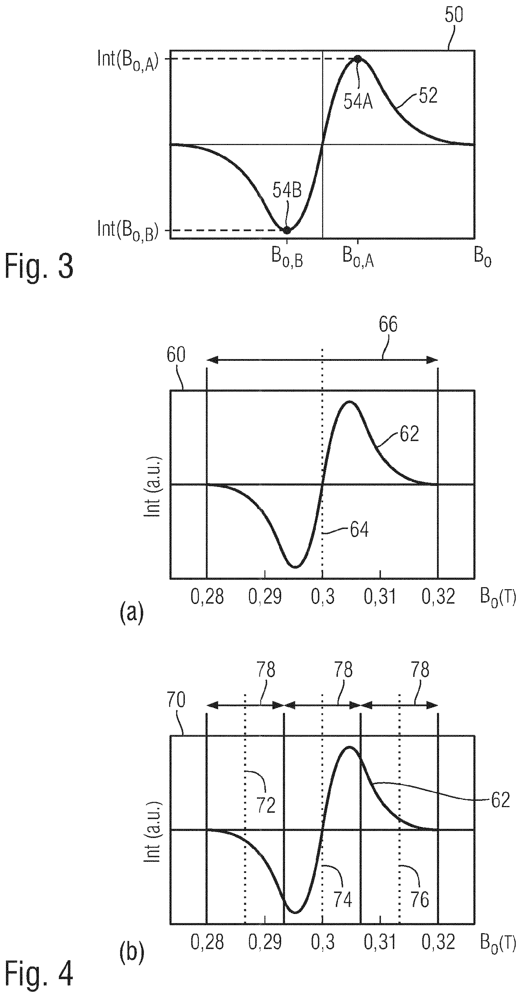

Zur weiteren Erläuterung der Funktionsweise der vorliegenden Erfindung zeigt das Diagramm 50 der Fig. 3 das vereinfachte Spektrum 52 einer Spinresonanz-Linie, vorliegend beispielsweise der Spinresonanz-Linie des Spinresonanz-Merkmals 12 der Banknote 10 als Funktion des Polarisationsfelds B₀ bei fester Anregefrequenz f. Dabei kann, abhängig von den Details der elektronischen Detektionsschaltung, das Maximum links oder rechts der Mitte liegen.

Da die Larmorfrequenz des Spinresonanz-Merkmals 12 proportional zum Polarisationsfeld B₀ ist, entspricht der in Fig. 3 dargestellte Kurvenverlauf 52 zugleich einem Frequenzspektrum der Spinresonanz-Linie. Im Kurvenverlauf 52 sind zwei charakteristische Spektralkomponenten 54A, 54B bei den oben angegebenen Polarisationsfeldstärken B_{0,A} bzw. B_{0,B} am Ort der Resonatoren 44 bzw. 46 eingezeichnet.

Wird Resonatoreinrichtung 40 der Fig. 2 bei einer bestimmten Feldstärke des von der Polarisationseinrichtung 34 erzeugten Polarisationsfelds von der Banknote 10 mit dem Spinresonanz-Merkmal 12 überstrichen, so detektiert jeder der beiden Streifenleitungs-Resonatoren 44, 46 die zu seiner Resonanzfrequenz gehörige Spektralkomponente 54A bzw. 54B des Spinresonanz-Merkmals 12.

Konkret misst der Streifenleitungs-Resonator 44 an der Position x_{A} die spektrale Intensität Int(B_{0,A}) der zur Feldstärke B_{0,A} gehörenden Spektralkomponente 54A und der Streifenleitungs-Resonator 46 an der Position x_{B} die spektrale Intensität Int(B_{0,B}) der zur Feldstärke B_{0,B} gehörenden Spektralkomponente 54B.

Wie oben bereits grundsätzlich erläutert, wird bei einer realen Echtheitsprüfung das statische magnetische Feld B₀ der Polarisationseinrichtung 34 mit Hilfe einer Rampspule zusätzlich um die Resonanzfeldstärke herum variiert und damit die Feldstärke des Polarisationsfelds B₀ bei fester Frequenz f des Anregefelds durchfahren, um die Aufnahme eines Frequenzspektrums der Resonanz des Merkmals 12 zu erlauben.

Der Vorteil erfindungsgemäßer Gestaltungen wird mit Bezug auf die Diagramme 60, 70 der Fig. 4 am Beispiel eines Spinresonanz-Merkmals 12 mit nur einer Spinresonanz-Linie näher erläutert. Die in den Figuren vereinfacht dargestellte Spinresonanz-Linie 62 des Merkmals 12 weist im Raum der Polarisationsfeldstärke beispielsweise eine Linienbreite - entsprechend dem Abstand von Minimum zu Maximum - von 10 mT auf.

Wird zur Aufzeichnung des Spinresonanz-Spektrums ein herkömmlicher Einzelresonator eingesetzt, so ist für eine vollständige Erfassung der spektralen Signatur bei einer Linienbreite von 10 mT eine Feldrampe 66 über einen Bereich von etwa 40 mT erforderlich, wie in Fig. 4(a) illustriert.

Im dargestellten Vergleichsbeispiel wird das Spektrum in einem homogenen Polarisationsfeld mit einem Einzelresonator mit einer Resonanzfrequenz von f = 8,41 GHz aufgezeichnet. Bei der Resonanzfeldstärke 64, hier beispielsweise 300 mT, entspricht diese Frequenz gerade der Larmorfrequenz des Spinresonanz-Merkmals 12. Wie in Fig. 4(a) gezeigt, muss um die Resonanzfeldstärke 64 herum eine Feldrampe 66 mit einer Amplitude von -20 mT bis +20 mT durchfahren werden, um die Spinresonanz-Linie 62 mit ihrer Linienbreite von 10 mT vollständig vermessen zu können. Mit einer solch großen Feldrampe sind lange Messzeiten und ein hoher Strombedarf verbunden.

Wird dagegen zur Aufzeichnung des Spektrums ein inhomogenes Polarisationsfeld und eine Resonatoreinrichtung 40 mit mehreren beabstandet angeordneten Streifenleitungs-Resonatoren nach der vorliegenden Erfindung eingesetzt, so kann eine wesentlich kürzere Messzeit und ein wesentlich geringerer Strombedarf erreicht werden.

Mit Bezug auf Fig. 4(b) enthält die Resonatoreinrichtung 40 eines erfindungsgemäßen Sensorelements 30 beispielsweise drei, in Transportrichtung beabstandet hintereinander angeordnete Streifenleitungs-Resonatoren, die alle eine Resonanzfrequenz von f = 8,41 GHz aufweisen. Die Streifenleitungs-Resonatoren sind im Ausführungsbeispiel so im Luftspalt angeordnet und auf den von der Polarisationseinrichtung 34 erzeugten inhomogenen magnetischen Fluss abgestimmt, dass an der Position des ersten Streifenleitungs-Resonators eine Feldstärke 72 von 287 mT, an der Position des zweiten Streifenleitungs-Resonators eine Feldstärke 74 von 300 mT, und an der Position des dritten Streifenleitungs-Resonators eine Feldstärke 76 von 313 mT herrscht.

Das Spinresonanzsignal des Merkmals 12 kann daher bei der festen Anregefrequenz von beispielsweise f = 8,41 GHz bei drei verschiedenen Polarisationsfeldstärken 72, 74, 76 gleichzeitig gemessen werden. Wie aus Fig. 4(b) ersichtlich, genügt zur vollständigen Erfassung der spektralen Signatur der Spinresonanz-Linie 62 dann eine wesentlich kleinere Feldrampe 78 mit einer Amplitude von nur etwa -6,5 mT bis 6,5 mT, einsprechend im Wesentlichen einem Drittel der Amplitude der herkömmlich benötigten Feldrampe 66 der Fig. 4(a).

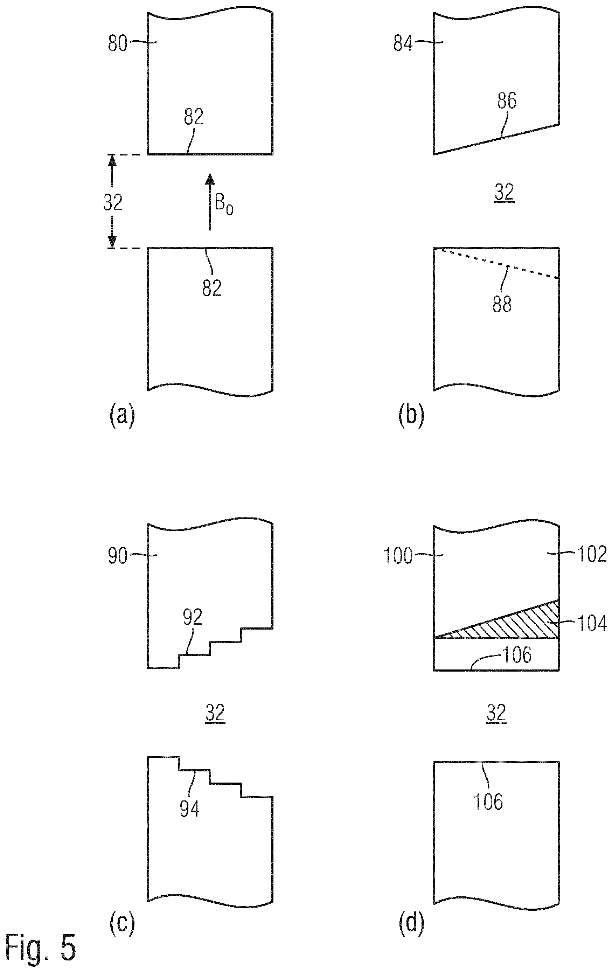

Es gibt eine Reihe von Möglichkeiten, einen inhomogenen magnetischen Fluss im Luftspalt des Magnetkreises zu erzeugen, wie mit Bezug auf die Fig. 5 anhand einiger vorteilhafter Ausgestaltungen illustriert. Bei einem herkömmlichen Magnetkern 80 sind die den Luftspalt 32 des homogenen Magnetkerns bildenden Polflächen 82 planparallel angeordnet, wie in Fig. 5(a) gezeigt. Bei einem solchen homogenen Magnetkern 80 erzeugt die Polarisationseinrichtung ein homogenes Magnetfeld B₀ im Luftspalt 32, das für die vorliegende Erfindung nicht geeignet ist.

Bei einem Magnetkern 84 nach einem ersten Ausführungsbeispiel der Erfindung ist eine der Polflächen 86 des Magnetkerns 84 in einem definierten Winkel abgeschrägt, wie in Fig. 5(b) dargestellt. Es können auch beide Polflächen 86, 88 des Magnetkerns 84 abgeschrägt sein, wie in Fig. 5(b) ebenfalls angedeutet. Der von den beiden Polflächen gebildete Winkel liegt insbesondere zwischen 1° und 10°, beispielsweise bei 5°. Ein Magnetkern 84 mit abgeschrägten Polflächen 86 bzw. 86, 88 ist mechanisch einfach zu realisieren. Die Feldstärke B₀ im Luftspalt 32 variiert dabei umgekehrt proportional zum lokalen Abstand zwischen den Polflächen, beispielsweise nimmt die Feldstärke des Polarisationsfelds B₀ in der Orientierung der Fig. 5(b) von links nach rechts linear ab.

Bei einem anderen Ausführungsbeispiel können eine oder beide Polflächen des Magnetkerns 90 auch stufig ausgebildet sein, wie im Ausführungsbeispiel der Fig. 5(c) gezeigt, bei dem beide Polflächen 92, 94 stufenförmig ausgebildet sind. Die Feldstärke B₀ im Luftspalt 32 hat dabei einen stufenförmigen Verlauf und nimmt beispielsweise bei der Orientierung der Fig. 5(c) von links nach rechts stufenförmig ab. Ein stufenförmiger Verlauf des Polarisationsfelds B₀ hat den Vorteil, dass die Streifenleitungs-Resonatoren jeweils in einem Bereich mit lokal konstanter Feldstärke angeordnet sein können, so dass die Streifenleitungs-Resonatoren ein unterschiedliches, aber jeweils über ihre Flächenausdehnung konstantes Polarisationsfeld B_{0,A}, B_{0,B} etc. erfahren.

Ein Magnetkern 100 nach einem weiteren Ausführungsbeispiel ist in Fig. 5(d) gezeigt. Bei diesem Ausführungsbeispiel ist der magnetische Leiter 102 des Magnetkerns 100 mit einem keilförmigen Flussleitstück 104 versehen, dessen magnetischer Widerstand größer ist als der magnetische Widerstand des Leiters 102 selbst. Das Flussleitstück 104 führt durch seine Keilform zu einer ortsabhängigen Variation des im Luftspalt 32 erzeugten Magnetfelds und damit zu einem inhomogenen Polarisationsfeld.

Durch die Formgebung des Flussleitstücks 104 kann ein gewünschter Verlauf des inhomogenen Polarisationsfelds eingestellt werden. Beispielsweise führt die in Fig. 5(d) gezeigte Keilform zu einer linearen Zu- bzw. Annahme des Polarisationsfelds im Luftspalt. Durch ein stufenförmiges Flussleitstück kann auch ein stufenförmiger Verlauf des Polarisationsfelds B₀ erzeugt werden. Ein Vorteil der Ausgestaltung mit einem Flussleitstück 104 besteht darin, dass die Polflächen 106 des Magnetkerns 100 selbst planparallel sein können, was einen ungestörten Transport der Banknotenprüflinge durch den Luftspalt 32 erleichtert. Das Flussleitstück 104 kann direkt am Luftspalt 32 liegen, oder, wie in Fig. 5(d) gezeigt, nahe des Luftspalts, wobei die Polfläche 106 jedoch von einem weiteren Element gebildet wird, das beispielsweise aus demselben Material wie der Magnetkern 100 bestehen kann.

Um die Funktionsweise der Erfindung zu demonstrieren, wurde das Verhalten eines Sensorelements mit einer Resonatoreinrichtung mit zwei quadratischen λ/2-Streifenleitungs-Resonatoren nach Fig. 2 simuliert.

Die Streifenleitungs-Resonatoren 44, 46 sind dabei auf einer Leiterplatte 42 der Stärke 1,5 mm aufgebaut, deren Dielektrizitätskonstante 3,66 beträgt. Die Resonatoren 44, 46 haben einen Abstand von 15 mm entlang der Banknoten-Transportrichtung 14. Die Kantenlänge der Resonatoren beträgt 7,1 mm, entsprechend einer Resonanzfrequenz von 9,8 GHz.

Die beiden Resonatoren 44, 46 werden über Zirkulatoren mit unabhängigen 50 Ω-Signalquellen betrieben, die mit gleicher Leistung im Dauerstrich (CW)-Modus auf der Resonanzfrequenz laufen. Zur Ankopplung an die Signalquelle sind die Resonatoren durch eine Durchkontaktierung in der Leiterplatte 42 angebunden. Die Durchkontaktierung hat dabei einen Abstand von 2,2 mm zur Resonatorkante. An diesem Punkt beträgt die Resonator-Impedanz 50 Ω.

Die so aufgebaute Resonatoreinrichtung 40 wird in den Luftspalt eines magnetischen Kreises eingebaut. Der Luftspalt ist durch zwei Polflächen eines Magnetkerns 84 begrenzt, wobei wie in Fig. 5(b) eine der beiden Polflächen planparallel zur Ebene der zu prüfenden Banknoten ist, währen die zweite Polfläche 86 abgeschrägt ist und in einem Winkel von 5° zur Banknotenebene verläuft. Durch diese Gestaltung wird im Luftspalt ein Polarisationsfeld B₀ mit inhomogener magnetischer Flussdichte erzeugt.

Konkret entsteht durch die Abschrägung ein in Transportrichtung linear zunehmendes Polarisationsfeld B₀ mit einem Gradienten von 3 mT/mm. Die Feldstärke des Polarisationsfelds B₀ an der Position des zweiten Streifenleitungs-Resonators 46 beträgt im Ausführungsbeispiel B_{0,B} = 300 mT, und die Feldstärke an der Position des ersten Streifenleitungs-Resonators 44 beträgt B_{0,A} = 345 mT. Das inhomogene Polarisationsfeld ist von einem räumlich konstanten Modulationsfeld B_{mod} überlagert.

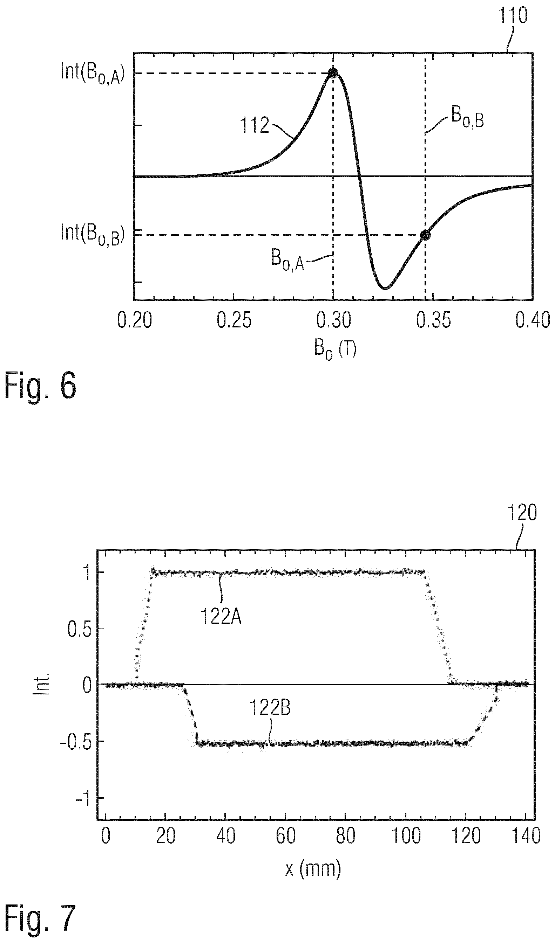

Anschließend wurde eine Papierprobe der Länge 100 mm über ihre Fläche homogen mit einem Spinresonanz-Merkmal beladen, dessen Spektrum 112 im Diagramm 110 der Fig. 6 dargestellt ist. Die Polarisationsfeldstärken B_{0,A} und B_{0,B} am Ort der Resonatoren 44, 46 und die zugehörigen relativen Signalintensitäten Int(B_{0,A}) und Int(B_{0,B}) sind ebenfalls eingezeichnet.

Die Papierprobe mit diesem Spinresonanz-Merkmal wird über die Resonatoreinrichtung 40 transportiert und mit den beiden Resonatoren 44, 46 die Signalintensität des Spinresonanz-Merkmals aufgezeichnet. Die erhaltenen Signalkurven 122A (Resonator 44) und 112B (Resonator 46) sind im Diagramm 120 der Fig. 7 dargestellt, das die gemessenen Signalintensitäten in Abhängigkeit vom Ort x zeigt. Die Signalkurven wurden dabei auf die mittlere Signalintensität der Signalkurve 122A normiert.

Durch Mittelung der Signalintensität im Plateaubereich jeder Signalkurve 122A, 122B erhält man ein Verhältnis der Signalintensität des ersten Resonators 44 zu der Signalintensität des zweiten Resonators 46 von 1,0/-0,55, was sehr gut mit dem aus dem Resonanzspektrum der Fig. 6 erwarteten Verhältnis Int(B_{0,A})/Int(B_{0,B}) übereinstimmt.

Bei den bisher beschriebenen Anordnungen sind die Streifenleitungs-Resonatoren der Resonatoreinrichtung so platziert und dimensioniert, dass die Feldstärke des Polarisationsfelds B₀ an der Position der Resonatoren in Verbindung mit der Resonatorfrequenz im Wesentlichen innerhalb der Linienbreite der zu messenden Larmorfrequenz liegt. Es ist aber auch möglich, einen Streifenleitungs-Resonator so zu platzieren, dass die dort herrschende Feldstärke keiner der erwarteten Larmorfrequenzen entspricht.

Mit einem solchen Resonator kann dann ein Negativnachweis durchgeführt werden, das heißt, für eine echte Banknote wird für diesen Resonator kein Spinresonanz-Signal erwartet.

### Bezugszeichenliste

- 10: Banknotenprüfling
- 12: Spinresonanz-Merkmal
- 14: Transportpfad
- 20: Prüfvorrichtung
- 22: Signalquelle
- 24: Duplexer
- 26: Detektor-Diode
- 28: Auswerteeinheit
- 30: Sensorelement
- 32: Luftspalt
- 34: Polarisationseinrichtung
- 35: Magnetkern
- 36: Modulationseinrichtung
- 40: Resonatoreinrichtung
- 42: Träger
- 44, 46: Streifenleitungs-Resonatoren
- 48: Verlauf des inhomogenen Polarisationsfelds
- 50: Diagramm
- 52: Spektrum einer Spinresonanz-Linie
- 54A, 54B: Spektralkomponenten
- 60: Diagramm
- 62: Spinresonanz-Linie
- 64: Resonanzfeldstärke
- 66: Feldrampe
- 70: Diagramm
- 72, 74, 76: Polarisationsfeldstärken
- 78: Feldrampe
- 80: Polarisationseinrichtung
- 82: planparallele Polflächen
- 84: Polarisationseinrichtung
- 86, 88: abgeschrägte Polflächen
- 90: Polarisationseinrichtung
- 92, 94: stufenförmige Polflächen
- 100: Polarisationseinrichtung
- 102: magnetischer Leiter
- 104: Flussleitstück
- 106: planparallele Polflächen
- 110: Diagramm
- 112: Spektrum des Spinresonanz-Merkmals
- 120: Diagramm
- 122A, 122B: Signalkurven

## Patentansprüche

1. Sensorelement (30) für die Prüfung eines Wert- oder Ausweisdokuments (10), insbesondere einer Banknote, mit einem Spinresonanz-Merkmal (12), mit
- einem Magnetkern mit einem Luftspalt (32), in den das Wert- oder Ausweisdokument (10) zur Prüfung einbringbar ist,
- einer Polarisationseinrichtung (34) zu Erzeugung eines statischen magnetischen Flusses in dem Luftspalt (32), und
- einer Resonatoreinrichtung (40) zur Anregung des Spinresonanz-Merkmals (12) des zu prüfenden Wert- oder Ausweisdokuments in dem Luftspalt,
wobei
- die Resonatoreinrichtung (40) zumindest zwei, an verschiedenen Positionen (x_{A}, x_{B}) im Luftspalt (32) angeordnete Streifenleitungs-Resonatoren (44, 46) enthält, und
- die Polarisationseinrichtung (34) in dem Luftspalt (32) des Magnetkerns einen inhomogenen magnetischen Fluss erzeugt, so dass der statische magnetische Fluss an der Position (x_{A}) eines ersten Streifenleitungs-Resonators (44) eine erste Feldstärke aufweist und an der Position (x_{B}) eines zweiten Streifenleitungs-Resonators (46) eine zweite, unterschiedliche Feldstärke aufweist.

2. Sensorelement (30) nach Anspruch 1, **dadurch gekennzeichnet, dass** die Streifenleitungs-Resonatoren (44, 46) der Resonatoreinrichtung (40) in Form eines eindimensionalen Arrays angeordnet sind, vorzugsweise, dass das eindimensionale Array parallel zu einem Gradienten des magnetischen Flusses im Luftspalt (32) angeordnet ist.

3. Sensorelement (30) nach Anspruch 1, **dadurch gekennzeichnet, dass** die Streifenleitungs-Resonatoren der Resonatoreinrichtung (40) eine Mehrspur-Anordnung mit mehreren parallelen Spuren bilden, bei der jede Spur durch ein eindimensionales Array von Streifenleitungs-Resonatoren gebildet ist, wobei vorzugsweise das eindimensionale Array jeder Spur parallel zu einem Gradienten des magnetischen Flusses im Luftspalt angeordnet ist.

4. Sensorelement (30) nach wenigstens einem der Ansprüche 1 bis 3, **dadurch gekennzeichnet, dass** die an verschiedenen Positionen im Luftspalt angeordneten Streifenleitungs-Resonatoren (44, 46) jeweils von einer anderen Signalquelle gespeist sind.

5. Sensorelement (30) nach wenigstens einem der Ansprüche 1 bis 4, **dadurch gekennzeichnet, dass** der Luftspalt (32) durch zwei Polflächen des Magnetkerns begrenzt ist, wobei eine oder beide Polflächen abgeschrägt und/oder gestuft ausgebildet sind, wobei das Sensorelement insbesondere **dadurch gekennzeichnet ist, dass** die beiden Polflächen einen Winkel zueinander bilden, der vorzugsweise zwischen 1° und 10° liegt.

6. Sensorelement (30) nach wenigstens einem der Ansprüche 1 bis 5, **dadurch gekennzeichnet, dass** die Streifenleitungs-Resonatoren (44, 46) der Resonatoreinrichtung (40) dieselbe Resonanzfrequenz aufweisen, bevorzugt, dass die Streifenleitungs-Resonatoren (44, 46) zudem auf eine Prüfung des Spinresonanz-Merkmals in derselben räumlichen Mode des Anregefelds ausgelegt und eingerichtet sind, besonders bevorzugt, dass die Streifenleitungs-Resonatoren (44, 46) eine gleiche geometrische Form aufweisen.

7. Sensorelement (30) nach wenigstens einem der Ansprüche 1 bis 6, **dadurch gekennzeichnet, dass** sich die genannte erste Feldstärke um mindestens 2%, vorzugsweise um mindestens 5%, insbesondere um mindestens 10% von der genannten zweiten Feldstärke unterscheidet.

8. Sensorelement (30) nach wenigstens einem der Ansprüche 1 bis 7, **dadurch gekennzeichnet, dass** das Sensorelement eine Modulationseinrichtung (36) zur Erzeugung eines zeitlich variierenden magnetischen Modulationsfelds in dem Luftspalt aufweist, wobei bevorzugt die Modulationsfrequenz am Ort jedes der Streifenleitungs-Resonatoren der Resonatoreinrichtung gleich hoch ist, wobei das Sensorelement insbesondere **dadurch gekennzeichnet ist, dass** die Modulationseinrichtung (36) durch eine im Luftspalt angeordnete Einzel-Modulationsspule, insbesondere eine Einzel-Planarspule, gebildet ist.

9. Sensorelement (30) nach wenigstens einem der Ansprüche 1 bis 8, **dadurch gekennzeichnet, dass** die Streifenleitungs-Resonatoren (44, 46) flächig mit einer Haupterstreckungsebene ausgebildet sind, welche senkrecht auf der Richtung des von der Polarisationseinrichtung erzeugten statischen magnetischen Flusses steht; und/oder
**dadurch gekennzeichnet, dass** der Luftspalt (32) eine Höhe von weniger als 10 mm, vorzugsweise von weniger als 5 mm aufweist; und/oder
**dadurch gekennzeichnet, dass** das Sensorelement eine Rampspule zur Erzeugung einer Rampenfunktion des statischen magnetischen Flusses aufweist.

10. Prüfvorrichtung (20) für die Prüfung eines Wert- oder Ausweisdokuments, insbesondere einer Banknote, mit einem Spinresonanz-Merkmal, mit
- einem Sensorelement (30) nach einem der Ansprüche 1 bis 9,
- einer oder mehreren Signalquelle(n) (22), aus denen die an verschiedenen Positionen im Luftspalt angeordneten Streifenleitungs-Resonatoren (44, 46) der Resonatoreinrichtung (40) gespeist sind,
- einem Detektor zur Messung der von der Resonatoreinrichtung (40) reflektierten Hochfrequenzleistung, und
- einer Auswerteeinheit (28) zur Auswertung und gegebenenfalls Anzeige des Messergebnisses.

11. Prüfvorrichtung (20) nach Anspruch 10, **dadurch gekennzeichnet, dass** mehrere Signalquellen vorgesehen sind, aus denen jeweils einer der an verschiedenen Positionen im Luftspalt angeordneten Streifenleitungs-Resonatoren (44, 46) der Resonatoreinrichtung (40) gespeist ist.

12. Prüfvorrichtung (20) nach Anspruch 10 oder 11, mit einer Transporteinrichtung, die die zu prüfenden Wert- oder Ausweisdokumente (10) entlang eines Transportpfades (14) durch den Luftspalt des Magnetkerns führt, wobei der Transportpfad vorteilhaft parallel zu einem Gradienten des magnetischen Flusses im Luftspalt ist, und wobei bevorzugt
- entweder die Streifenleitungs-Resonatoren (44, 46) der Resonatoreinrichtung (40) nach Anspruch 2 oder einem auf Anspruch 2 rückbezogenen Anspruch in Form eines eindimensionalen Arrays parallel zu dem Transportpfad (14) angeordnet sind,
- oder die Streifenleitungs-Resonatoren eine Mehrspur-Anordnung nach Anspruch 3 oder einem auf Anspruch 3 rückbezogenen Anspruch bilden, bei der jede der Spuren parallel zu dem Transportpfad (14) ist,
wobei die Prüfvorrichtung insbesondere **dadurch gekennzeichnet ist, dass** die Transporteinrichtung auf einen schnell-laufenden Transport der zu prüfenden Wert- oder Ausweisdokumente entlang des Transportpfades (14) ausgelegt und eingerichtet ist.

13. Verfahren zur Prüfung eines Wert- oder Ausweisdokuments (10), insbesondere einer Banknote, mit einem Spinresonanz-Merkmal (12) mittels eines Sensorelements (30) nach einem der Ansprüche 1 bis 9 oder einer Prüfvorrichtung (20) nach einem der Ansprüche 10 bis 12, wobei bei dem Verfahren
- ein zu prüfendes Wert- oder Ausweisdokument (10) entlang eines Transportpfades durch den Luftspalt des Magnetkerns des genannten Sensorelements (30) geführt wird, wobei eine Mehrzahl von Streifenleitungs-Resonatoren (44, 46) der Resonatoreinrichtung (40) parallel zu dem Transportpfad hintereinander liegen,
- mit der Polarisationseinrichtung (34) in dem Luftspalt (32) des Magnetkerns ein inhomogener magnetischer Fluss und vorzugsweise mit einer Modulationseinrichtung (36) ein zeitlich variierendes magnetisches Modulationsfeld in dem Luftspalt erzeugt wird, und
- mit der Resonatoreinrichtung (40) das Spinresonanz-Merkmal (12) des zu prüfenden Wert- oder Ausweisdokuments (10) angeregt wird.

14. Verfahren nach Anspruch 13, **dadurch gekennzeichnet, dass**
- das zu prüfende Wert- oder Ausweisdokument (10) an den hintereinander liegenden Streifenleitungs-Resonatoren (44, 46) vorbeigeführt wird, und von den Streifenleitungs-Resonatoren jeweils eine zeitliche Messreihe des nach Anregung erzeugten Antwortsignals des Spinresonanz-Merkmals (12) aufgenommen wird,
- aus den zeitlichen Messreihen der Streifenleitungs-Resonatoren jeweils zum selben Messfleck gehörende Messdaten identifiziert werden,
- aus den identifizierten Messdaten eine spektrale Information über das Spinresonanz-Merkmal (12) abgeleitet wird, und
- das Wert- oder Ausweisdokument (10) anhand der abgeleiteten spektralen Information bewertet wird, insbesondere auf Echtheit und/oder Zugehörigkeit zu einer Datenträgerklasse.

15. Verfahren nach Anspruch 13 oder 14, **dadurch gekennzeichnet, dass** die Messdaten räumlich aufgelöst oder räumlich gemittelt werden; und/oder
**dadurch gekennzeichnet, dass**
- dem inhomogenen statischen magnetischen Fluss ein räumlich homogenes Rampfeld überlagert wird, so dass der gesamte statische magnetische Fluss im Luftspalt (32) zeitlich zwischen einem Minimalwert und einem Maximalwert variiert,
- die spektrale Information aus den identifizierten Messdaten unter Berücksichtigung der Feldstärke des statischen magnetischen Flusses zum jeweiligen Messzeitpunkt abgeleitet wird, und
- anhand der abgeleiteten spektralen Information die Echtheit des geprüften Wert- oder Ausweisdokuments (10) und/oder die Zugehörigkeit des geprüften Wert- oder Ausweisdokuments (10) zu einer von mehreren Datenträgerklassen mit unterschiedlichen Spektralsignaturen bestimmt wird.

## Claims

1. Sensor element (30) for checking a document of value or identification (10), in particular a banknote, with a spin resonance feature (12), with
- a magnetic core with an air gap (32) into which the security or identification document (10) can be inserted for verification,
- a polarization device (34) for generating a static magnetic flux in the air gap (32), and
- a resonator device (40) for exciting the spin resonance feature (12) of the security or identification document (10) to be checked in the air gap,
wherein
- the resonator device (40) contains at least two strip line resonators (44, 46) arranged at different positions (x_{A}, x_{B}) in the air gap (32), and
- the polarization device (34) generates an inhomogeneous magnetic flux in the air gap (32) of the magnetic core, so that the static magnetic flux at the position (x_{A} ) of a first strip line resonator (44) has a first field strength and at the position (x_{B} ) of a second strip line resonator (46) has a second, different field strength.

2. Sensor element (30) according to claim 1, **characterized in that** the strip line resonators (44, 46) of the resonator device (40) are arranged in the form of a one-dimensional array, preferably **in that** the one-dimensional array is arranged parallel to a gradient of the magnetic flux in the air gap (32).

3. Sensor element (30) according to claim 1, **characterized in that** the strip line resonators of the resonator device (40) form a multi-track arrangement with several parallel tracks, in which each track is formed by a one-dimensional array of strip line resonators, preferably the one-dimensional array of each track being arranged parallel to a gradient of the magnetic flux in the air gap.

4. Sensor element (30) according to at least one of claims 1 to 3, **characterized in that** the strip line resonators (44, 46) arranged at different positions in the air gap are each fed by a different signal source.

5. Sensor element (30) according to at least one of claims 1 to 4, **characterized in that** the air gap (32) is bounded by two pole faces of the magnetic core, wherein one or both pole faces are bevelled and/or stepped, wherein the sensor element is **characterized in** particular **in that** the two pole faces form an angle with each other which is preferably between 1° and 10°.

6. Sensor element (30) according to at least one of claims 1 to 5, **characterized in that** the strip line resonators (44, 46) of the resonator device (40) have the same resonance frequency, preferably that the strip line resonators (44, 46) are also designed and configured to test the spin resonance characteristic in the same spatial mode as the excitation field, and particularly preferably that the strip line resonators (44, 46) have the same geometric shape.

7. Sensor element (30) according to at least one of claims 1 to 6, **characterized in that** said first field strength differs from said second field strength by at least 2%, preferably by at least 5%, in particular by at least 10%.

8. Sensor element (30) according to at least one of claims 1 to 7, **characterized in that** the sensor element has a modulation device (36) for generating a time-varying magnetic modulation field in the air gap, wherein the modulation frequency is preferably the same at the location of each of the stripline resonators of the resonator device, wherein the sensor element is **characterized in** particular **in that** the modulation device (36) is formed by a single modulation coil, in particular a single planar coil, arranged in the air gap.

9. Sensor element (30) according to at least one of claims 1 to 8, **characterized in that** the strip line resonators (44, 46) are formed flat with a main extension plane which is perpendicular to the direction of the static magnetic flux generated by the polarization device; and/or
**characterized in that** the air gap (32) has a height of less than 10 mm, preferably less than 5 mm; and/or
**characterized in that** the sensor element has a ramp coil ( ) for generating a ramp function ( ) of the static magnetic flux.

10. Testing device (20) for testing a value or identification document, in particular a banknote, with a spin resonance feature, with
- a sensor element (30) according to any one of claims 1 to 9,
- one or more signal sources (22) from which the strip line resonators (44, 46) of the resonator device (40) arranged at different positions in the air gap are fed,
- a detector for measuring the high-frequency power reflected by the resonator device (40), and
- an evaluation unit (28) for evaluating and, if necessary, displaying the measurement result.

11. Test device (20) according to claim 10, **characterized in that** a plurality of signal sources are provided, each of which feeds one of the strip line resonators (44, 46) of the resonator device (40) arranged at different positions in the air gap.

12. Test device (20) according to claim 10 or 11, with a transport device that guides the value or identification documents (10) to be tested along a transport path (14) through the air gap of the magnetic core, wherein the transport path is advantageously parallel to a gradient of the magnetic flux in the air gap, and wherein preferably
- either the strip line resonators (44, 46) of the resonator device (40) according to claim 2 or a claim referring back to claim 2 are arranged in the form of a one-dimensional array parallel to the transport path (14),
- or the strip line resonators form a multi-track arrangement according to claim 3 or a claim referring back to claim 3, in which each of the tracks is parallel to the transport path (14),
the testing device being **characterized in** particular **in that** the transport device is designed and set up for fast transport of the valuable documents or identity documents to be tested along the transport path (14).

13. Method for testing a value or identification document (10), in particular a banknote, with a spin resonance feature (12) by means of a sensor element (30) according to one of claims 1 to 9 or a testing device (20) according to one of claims 10 to 12, wherein in the method
- a document of value or identification (10) to be verified is guided along a transport path through the air gap of the magnetic core of said sensor element (30), wherein a plurality of strip line resonators (44, 46) of the resonator device (40) are arranged in parallel to the transport path one behind the other,
- an inhomogeneous magnetic flux is generated in the air gap (32) of the magnetic core using the polarization device (34) and, preferably, a time-varying magnetic modulation field is generated in the air gap using a modulation device (36), and
, the resonator device (40) excites the spin resonance feature (12) of the value or identification document (10) to be tested.

14. Method according to claim 13, **characterized in that**
- the security or identification document (10) to be examined is passed past the successive strip line resonators (44, 46), and a temporal measurement series of the response signal of the spin resonance feature (12) generated after excitation is recorded by each of the strip line resonators,
- measurement data belonging to the same measurement spot is identified from the time series of measurements of the strip line resonators,
- spectral information about the spin resonance feature (12) is derived from the identified measurement data, and
- the value or identification document (10) is evaluated on the basis of the derived spectral information, in particular with regard to authenticity and/or belonging to a data carrier class.

15. Method according to claim 13 or 14, **characterized in that** the measurement data is spatially resolved or spatially averaged; and/or
**characterized in that**
- a spatially homogeneous ramp field is superimposed on the inhomogeneous static magnetic flux, so that the entire static magnetic flux in the air gap (32) varies over time between a minimum value and a maximum value,
- the spectral information is derived from the identified measurement data, taking into account the field strength of the static magnetic flux at the respective measurement time, and
- the derived spectral information is used to determine the authenticity of the checked value or identification document (10) and/or the affiliation of the checked value or identification document (10) to one of several data carrier classes with different spectral signatures.

## Revendications

1. Élément capteur (30) pour contrôler un document de valeur ou une pièce d'identité (10), en particulier un billet de banque, avec une caractéristique de résonance de spin (12), avec
- un noyau magnétique avec un entrefer (32) dans lequel le document de valeur ou d'identité (10) peut être introduit pour être contrôlé,
- un dispositif de polarisation (34) pour générer un flux magnétique statique dans l'entrefer (32), et
- un dispositif résonateur (40) pour exciter la caractéristique de résonance de spin (12) du document de valeur ou d'identité à contrôler dans l'entrefer,
où
- le dispositif résonateur (40) comprend au moins deux résonateurs à ligne à ruban (44, 46) disposés à différentes positions (x_{A} , x_{B} ) dans l'entrefer (32), et
- le dispositif de polarisation (34) génère un flux magnétique non homogène dans l'entrefer (32) du noyau magnétique, de sorte que le flux magnétique statique présente une première intensité de champ à la position (x_{A} ) d'un premier résonateur à ligne triplaque (44) et une deuxième intensité de champ différente à la position (x_{B} ) d'un deuxième résonateur à ligne à ruban (46), présente une deuxième intensité de champ différente.

2. Élément capteur (30) selon la revendication 1, **caractérisé en ce que** les résonateurs à ligne à ruban (44, 46) du dispositif résonateur (40) sont disposés sous la forme d'un réseau unidimensionnel, de préférence **en ce que** le réseau unidimensionnel est disposé parallèlement à un gradient du flux magnétique dans l'entrefer (32).

3. Élément capteur (30) selon la revendication 1, **caractérisé en ce que** les résonateurs à ligne triplaque du dispositif résonateur (40) forment un agencement multipiste avec plusieurs pistes parallèles, dans lequel chaque piste est formée par un réseau unidimensionnel de résonateurs à ligne triplaque, le réseau unidimensionnel de chaque piste étant de préférence disposé parallèlement à un gradient du flux magnétique dans l'entrefer.

4. Élément capteur (30) selon au moins l'une des revendications 1 à 3, **caractérisé en ce que** les résonateurs à ligne à ruban (44, 46) disposés à différentes positions dans l'entrefer sont alimentés chacun par une source de signal différente.

5. Élément capteur (30) selon au moins l'une des revendications 1 à 4, **caractérisé en ce que** l'entrefer (32) est délimité par deux surfaces polaires du noyau magnétique, l'une ou les deux surfaces polaires étant biseautées et/ou étagées ( ), l'élément capteur étant notamment **caractérisé en ce que** les deux surfaces polaires forment entre elles un angle compris de préférence entre 1° et 10°.

6. Élément capteur (30) selon au moins l'une des revendications 1 à 5, **caractérisé en ce que** les résonateurs à ligne triplaque (44, 46) du dispositif résonateur (40) ont la même fréquence de résonance, de préférence **en ce que** les résonateurs à ligne triplaque (44, 46) sont en outre conçus et agencés pour tester la caractéristique de résonance de spin dans le même mode spatial du champ d'excitation, de préférence que les résonateurs à ligne triplaque (44, 46) présentent une forme géométrique identique.

7. Élément capteur (30) selon au moins l'une des revendications 1 à 6, **caractérisé en ce que** ladite première intensité de champ diffère d'au moins 2 %, de préférence d'au moins 5 %, en particulier d'au moins 10 %, de ladite deuxième intensité de champ.

8. Élément capteur (30) selon au moins l'une des revendications 1 à 7, **caractérisé en ce que** l'élément capteur comporte un dispositif de modulation (36) à modulation d' e pour générer un champ de modulation magnétique variant dans le temps dans l'entrefer, la fréquence de modulation étant de préférence la même à l'emplacement de chacun des résonateurs à ligne à ruban du dispositif résonateur, l'élément capteur étant caractérisé en particulier **en ce que** le dispositif de modulation (36) est formé par une bobine de modulation unique, en particulier une bobine plane unique, disposée dans l'entrefer.

9. Élément capteur (30) selon au moins l'une des revendications 1 à 8, **caractérisé en ce que** les résonateurs à ligne à ruban (44, 46) sont réalisés à plat avec un plan d'extension principal qui est perpendiculaire à la direction du flux magnétique statique généré par le dispositif de polarisation ; et/ou
**caractérisé en ce que** l'entrefer (32) présente une hauteur inférieure à 10 mm, de préférence inférieure à 5 mm ; et/ou
**caractérisé en ce que** l'élément capteur comporte une bobine à rampe e pour générer une fonction de rampe e du flux magnétique statique.

10. Dispositif de contrôle (20) pour contrôler un document de valeur ou une pièce d'identité, en particulier un billet de banque, avec une caractéristique de résonance de spin, avec
- un élément capteur (30) selon l'une des revendications 1 à 9,
- une ou plusieurs sources de signal (22) à partir desquelles sont alimentés les résonateurs à ligne à ruban (44, 46) du dispositif résonateur (40) disposés à différentes positions dans l'entrefer,
- un détecteur pour mesurer la puissance haute fréquence réfléchie par le dispositif résonateur (40), et
- une unité d'évaluation (28) pour évaluer et, le cas échéant, afficher le résultat de la mesure.

11. Dispositif de contrôle (20) selon la revendication 10, **caractérisé en ce que** plusieurs sources de signaux sont prévues, à partir desquelles est alimenté respectivement l'un des résonateurs à ligne à ruban (44, 46) du dispositif résonateur (40) disposés à différentes positions dans l'entrefer.

12. Dispositif de contrôle (20) selon la revendication 10 ou 11, comprenant un dispositif de transport qui guide les documents de valeur ou d'identité (10) à contrôler le long d'un chemin de transport (14) à travers l'entrefer du noyau magnétique, le chemin de transport étant avantageusement parallèle à un gradient du flux magnétique dans l'entrefer, et de préférence
- soit les résonateurs à ligne à bande (44, 46) du dispositif résonateur (40) selon la revendication 2 ou une revendication se référant à la revendication 2 sont disposés sous la forme d'un réseau unidimensionnel parallèle au chemin de transport (14),
- ou les résonateurs à ligne à ruban forment un agencement à plusieurs pistes selon la revendication 3 ou une revendication se référant à la revendication 3, dans lequel chacune des pistes est parallèle au chemin de transport (14),
le dispositif de contrôle étant notamment **caractérisé en ce que** le dispositif de transport est conçu et aménagé pour un transport rapide des documents de valeur ou d'identité à contrôler le long du chemin de transport (14).

13. Procédé de contrôle d'un document de valeur ou d'identité (10), en particulier d'un billet de banque, comportant une caractéristique de résonance de spin (12) à l'aide d'un élément capteur (30) selon l'une des revendications 1 à 9 ou d'un dispositif de contrôle (20) selon l'une des revendications 10 à 12, dans lequel, dans le procédé
- un document de valeur ou d'identité (10) à vérifier est guidé le long d'un chemin de transport à travers l'entrefer du noyau magnétique dudit élément capteur (30), une pluralité de résonateurs à ligne à bande (44, 46) du dispositif résonateur (40) étant disposés en parallèle au chemin de transport les uns derrière les autres,
- un flux magnétique non homogène est généré dans l'entrefer (32) du noyau magnétique à l'aide du dispositif de polarisation (34) et, de préférence, un champ de modulation magnétique variant dans le temps est généré dans l'entrefer à l'aide d'un dispositif de modulation (36), et
- le dispositif résonateur (40) excite la caractéristique de résonance de spin (12) du document de valeur ou d'identité (10) à contrôler.

14. Procédé selon la revendication 13, **caractérisé en ce que**
- le document de valeur ou d'identité (10) à contrôler est passé devant les résonateurs à ligne à ruban (44, 46) disposés les uns derrière les autres, et les résonateurs à ligne à ruban enregistrent chacun une série de mesures temporelles du signal de réponse de la caractéristique de résonance de spin (12) généré après excitation,
- les données de mesure appartenant au même point de mesure sont identifiées à partir des séries de mesures temporelles des résonateurs à ligne triplaque,
- une information spectrale sur la caractéristique de résonance de spin (12) est dérivée des données de mesure identifiées, et
- le document de valeur ou d'identité (10) est évalué à l'aide des informations spectrales dérivées, en particulier quant à son authenticité et/ou son appartenance à une classe de supports de données.

15. Procédé selon la revendication 13 ou 14, **caractérisé en ce que** les données de mesure sont résolues spatialement ou moyennées spatialement ; et/ou
**caractérisé en ce que**
- un champ en rampe spatialement homogène est superposé au flux magnétique statique non homogène, de sorte que l'ensemble du flux magnétique statique dans l'entrefer (32) varie dans le temps entre une valeur minimale et une valeur maximale,
- les informations spectrales sont dérivées des données de mesure identifiées en tenant compte de l'intensité du champ du flux magnétique statique au moment de la mesure respective, et
- l'authenticité du document de valeur ou d'identité (10) contrôlé et/ou l'appartenance du document de valeur ou d'identité (10) contrôlé à l'une de plusieurs classes de supports de données présentant différentes signatures spectrales est déterminée à l'aide des informations spectrales dérivées.
